# EUROPEAN PATENT APPLICATION

(11) **EP 4 171 189 A1**
(43) Date of publication of application: **26.04.2023**
(21) Application number: 22191805.5
(22) Date of filing: 23.08.2022
(51) Int. Cl.: H10B 53/30, H01L 21/28, G11C 11/22

(54) **SEMICONDUCTOR DEVICE AND SEMICONDUCTOR MEMORY DEVICE INCLUDING THE SAME**

(30) Priority: 19.10.2021 KR 20210138966
(71) Applicant: Samsung Electronics Co., Ltd., Gyeonggi-do, 16677 (KR)
(72) Inventor: LIM, Hanjin, 16677 Suwon-si (KR); PARK, Jungmin, 16677 Suwon-si (KR)
(74) Representative: Marks & Clerk LLP

(57) **Abstract**

Disclosed are a semiconductor device and a semiconductor memory device including the same. A semiconductor device may include a first electrode (BE), a second electrode (TE) on the first electrode, a ferroelectric layer (110) between the first electrode and the second electrode, an anti-ferroelectric layer (120) in contact with the ferroelectric layer, and an insertion layer (130) spaced apart from the ferroelectric layer and in contact with the anti-ferroelectric layer.

## Description

### BACKGROUND

The present disclosure relates to a semiconductor device and/or a semiconductor memory device including the same, and in particular, to a capacitor with improved electric characteristics and/or a semiconductor memory device including the same.

As the demand for small and high-performance electronic devices increases, the demand for miniaturization and high-performance may be required for an electronic component used in the electronic device, and an integration density of a semiconductor device is increasing to satisfy such requirements. The increase of the integration density in the semiconductor device means a reduction in a design rule of the semiconductor device and an abrupt reduction in a space occupied by an electronic device, such as a metal-insulator-metal (MIM) capacitor and a metal-oxide-semiconductor (MOS) transistor. It may be necessary to develop a dielectric layer capable of exhibiting a high-k dielectric property and a good operation property to overcome the restriction on the space occupied by an electronic device.

### SUMMARY

An embodiment of inventive concepts provides a semiconductor device with improved electric characteristics and a semiconductor memory device including the same.

According to an embodiment of inventive concepts, a semiconductor device may include a first electrode, a second electrode on the first electrode, a ferroelectric layer between the first electrode and the second electrode, an anti-ferroelectric layer in contact with the ferroelectric layer, and an insertion layer spaced apart from the ferroelectric layer and in contact with the anti-ferroelectric layer.

According to an embodiment of inventive concepts, a semiconductor device may include a first electrode, a second electrode on the first electrode, a ferroelectric layer between the first electrode and the second electrode, an anti-ferroelectric layer between the ferroelectric layer and the first electrode, and an insertion layer between the anti-ferroelectric layer and the first electrode. An energy band gap of the insertion layer may be greater than an energy band gap of the anti-ferroelectric layer.

According to an embodiment of inventive concepts, a semiconductor memory device may include a selection transistor; a word line configured to control the selection transistor; a bit line crossing the word line and connected to a source electrode of the selection transistor, and a capacitor connected to a drain electrode of the selection transistor. The capacitor may include a bottom electrode, a top electrode, and a capacitor dielectric layer between the bottom electrode and the top electrode. The capacitor dielectric layer may include a ferroelectric layer, an anti-ferroelectric layer between the ferroelectric layer and the bottom electrode or the top electrode, and an insertion layer. The insertion layer may be between the anti-ferroelectric layer and the bottom electrode or the top electrode.

At least some of the above and other features of the invention are set out in the claims.

### BRIEF DESCRIPTION OF THE DRAWINGS

FIG. 1 is a sectional view illustrating a semiconductor device according to an embodiment of inventive concepts.
FIG. 2 is an energy band diagram illustrating a semiconductor device according to an embodiment of inventive concepts.
FIG. 3 is a sectional view illustrating a semiconductor device according to an embodiment of inventive concepts.
FIG. 4 is an energy band diagram illustrating a semiconductor device according to an embodiment of inventive concepts.
FIGS. 5 to 9 are sectional views, each of which illustrates a semiconductor device according to an embodiment of inventive concepts.
FIG. 10 is a block diagram illustrating a semiconductor memory device including a semiconductor device according to an embodiment of inventive concepts.
FIG. 11 is a plan view illustrating a semiconductor memory device including a semiconductor device according to an embodiment of inventive concepts.
FIG. 12 is a sectional view, which is taken along lines I-I' and II-II' of FIG. 11 to illustrate a semiconductor memory device including a semiconductor device according to an embodiment of inventive concepts.

### DETAILED DESCRIPTION

Example embodiments of inventive concepts will now be described more fully with reference to the accompanying drawings, in which example embodiments are shown.

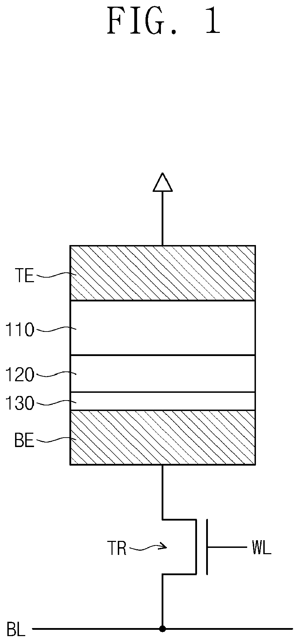

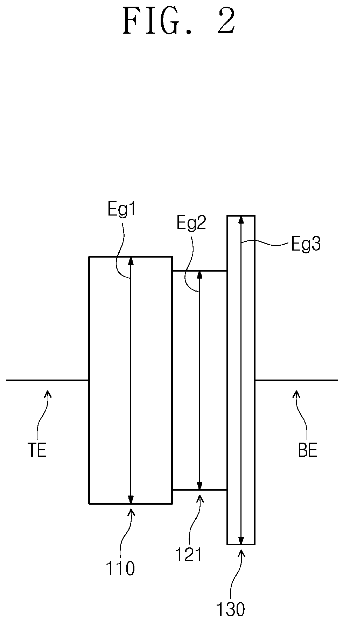

FIG. 1 is a sectional view illustrating a semiconductor device according to an embodiment of inventive concepts. FIG. 2 is an energy band diagram illustrating a semiconductor device according to an embodiment of inventive concepts.

Referring to FIGS. 1 and 2, a semiconductor device according to an embodiment of inventive concepts may include a first electrode BE, a second electrode TE, a ferroelectric layer 110, an anti-ferroelectric layer 120, and an insertion layer 130.

The first electrode BE may be opposite to the second electrode TE. In an embodiment, the first electrode BE may be a bottom electrode connected to a switching device TR, and the second electrode TE may be a top electrode connected to a ground terminal. As an example, the switching device TR may be a transistor (such as a metal-oxide-semiconductor (MOS) transistor) and may include a gate electrode connected to a word line WL, a source electrode connected to a bit line BL, and a drain electrode connected to the first electrode BE.

The first and second electrodes BE and TE may be formed of or include at least one of doped semiconductor materials, metallic materials, metal nitride materials, and metal silicide materials. As an example, the first and second electrodes BE and TE may be formed of or include at least one of high fusion point metals (e.g., cobalt, titanium, nickel, tungsten, and molybdenum). As another example, the first and second electrodes BE and TE may be formed of or include at least one of metal nitride materials (e.g., titanium nitride (TiN), titanium silicon nitride (TiSiN), titanium aluminum nitride (TiAIN), tantalum nitride (TaN), tantalum silicon nitride (TaSiN), tantalum aluminum nitride (TaAIN), and tungsten nitride (WN)). As other example, the first and second electrodes BE and TE may be formed of or include at least one of metal-semiconductor compounds (e.g., tungsten silicide, cobalt silicide, and titanium silicide). Alternatively, the first and second electrodes BE and TE may include at least one of noble metals (e.g., platinum (Pt), ruthenium (Ru), and iridium (Ir)). For example, the first and second electrodes BE and TE may be formed of or include at least one of conductive oxides of noble metals (e.g., PtO, RuO₂, and IrO₂) or conductive oxides (e.g., SRO(SrRuO₃), BSRO((Ba,Sr)RuO₃), CRO(CaRuO₃), LSCo).

The ferroelectric layer 110 may be disposed between the first electrode BE and the second electrode TE. As an example, the ferroelectric layer 110 may be adjacent to and in contact with the second electrode TE.

The ferroelectric layer 110 may be formed of or include at least one of high-k ferroelectric materials. Here, the high-k material may mean a material having a higher dielectric constant than silicon oxide. When comparing the "dielectric constant" of different layers this may be as measured at the same temperature and frequency (e.g. at room temperature (e.g. 293 K) and below 1 kHz).

The ferroelectric material may have spontaneously electric dipole; that is, it may have a spontaneous polarization. Even when there is no external electric field, the ferroelectric layer 110 may have a remnant polarization (e.g. non-zero polarization) caused by the dipole. In addition, a direction of the polarization may be switched by an external electric field, and such a switching may be achieved by units of domain.

The ferroelectric layer 110 may be formed of or include at least one of oxide materials containing hafnium (Hf) or zirconium (Zr). For example, the ferroelectric layer 110 may be formed of or include HfO₂, HfSiO₂ (Si-doped HfO₂), HfAlO₂ (Al-doped HfO₂), HfSiON, HfZnO, HfZrO₂, ZrO₂, ZrSiO₂, HfZrSiO₂, ZrSiON, LaAlO, HfDyO₂, or HfScO₂.

The ferroelectric layer 110 may have at least one of crystal structures such as tetragonal, monoclinic, and orthorhombic phases.

As an example, the ferroelectric layer 110 may be formed of or include hafnium oxide of tetragonal phase. To form the ferroelectric layer 110 in a tetragonal lattice structure, the ferroelectric layer 110 may include a seed layer (not shown).

The anti-ferroelectric layer 120 may be disposed between the ferroelectric layer 110 and the first electrode BE and may be in contact with the ferroelectric layer 110. The anti-ferroelectric layer 120 may be formed of or include an anti-ferroelectric material. The anti-ferroelectric material may have electric dipoles, and a remnant polarization thereof may be zero or may be close to zero. When an electric field is not applied to the anti-ferroelectric layer 120, dipoles, which are adjacent to each other, may have opposite directions, and thus, the polarizations thereof may be canceled. As a result, a total spontaneous polarization and a remnant polarization of the anti-ferroelectric layer 120 may be zero or may have a value close to zero. When an external electric field is applied to the anti-ferroelectric layer 120, the anti-ferroelectric layer 120 may exhibit a polarized property and a switching property. An anti-ferroelectric material may be a material that exhibits anti-ferroelectric properties (e.g. zero polarization in the absence of an external electric field and polarization in the presence of an external electric field) below a Neel temperature for the material. Above the Neel temperature, the material may exhibit different electric behavior.

The anti-ferroelectric layer 120 may have a second energy band gap Eg2, which is equal to or smaller than a first energy band gap Eg1 of the ferroelectric layer 110. When referring to an "energy band gap", this may refer to the energy required to promote a valence electron bound to an atom within the material to become a conduction electron. This may be the energy difference between the top of the valence band and the bottom of the conduction band. When comparing the energy band gap between two layers or materials, this may be achieved at the same temperature and/or pressure (for instance, 293 K at 1 atm (101325 Pa)).

As an example, the anti-ferroelectric layer 120 may be formed of or include zirconium oxide, hafnium oxide, or zirconium hafnium oxide. Here, the zirconium hafnium oxide may be zirconium oxide doped with hafnium. The anti-ferroelectric layer 120 may contain aluminum or silicon serving as dopants.

The anti-ferroelectric layer 120 may have a crystalline structure different from a crystalline structure of the ferroelectric layer 110. For a capacitor including the ferroelectric and anti-ferroelectric layers 110 and 120, since a dielectric material includes different kinds of crystalline structures, it may have a non-linear operation property. In this case, the capacitor may have an increased electrostatic capacity.

Meanwhile, a leakage current in the capacitor including the ferroelectric and anti-ferroelectric layers 110 and 120 may be increased, compared with a capacitor including a capacitor paraelectric material. Accordingly, in the embodiments of inventive concepts, a capacitor may include the insertion layer 130, which may be used to reduce the leakage current.

The insertion layer 130 may be disposed between the first and second electrodes BE and TE to be spaced apart from the ferroelectric layer 110. The insertion layer 130 may not be in contact with the ferroelectric layer 110 and may be in contact with the anti-ferroelectric layer 120. As an example, the insertion layer 130 may be disposed between the anti-ferroelectric layer 120 and the first electrode BE. A thickness of the insertion layer 130 may be smaller than a thickness of the anti-ferroelectric layer 120 and a thickness of the ferroelectric layer 110.

In an embodiment, the insertion layer 130 may be formed of or include a material having a third energy band gap Eg3, which is greater than the second energy band gap Eg2 of the anti-ferroelectric layer 120. Accordingly, the insertion layer 130 may serve as an energy barrier for limiting and/or preventing a leakage current.

In an embodiment, the anti-ferroelectric layer 120 may contain a first element, and the insertion layer 130 may contain a second element different from the first element. Here, the second element may have the same valence as the first element. Since the insertion layer 130 and the anti-ferroelectric layer 120 have the same valence, it may be possible to reduce an oxygen vacancy, which may occur at an interface between the ferroelectric layer 110 and the insertion layer 130. As an example, since the anti-ferroelectric layer 120 may contain zirconium (Zr) and the insertion layer 130 may contain silicon (Si).

The insertion layer 130 may contain a second element whose atomic radius is similar to that of the first element in the anti-ferroelectric layer 120. Accordingly, it may be possible to limit and/or prevent a leakage current, which is caused by a lattice mismatch between the insertion layer 130 and the anti-ferroelectric layer 120.

In an embodiment, since the insertion layer 130 is disposed to be spaced apart from the ferroelectric layer 110, it may be possible to limit and/or prevent a crystalline structure of the ferroelectric layer 110 from being affected by the insertion layer 130 when the ferroelectric layer 110 is formed. In other words, it may be possible to ensure a high-k dielectric constant and a crystalline structure of the ferroelectric layer 110 and to reduce a leakage current of a capacitor.

The insertion layer 130 may be formed of or include at least one insulating material (e.g., silicon oxide, silicon nitride, silicon oxynitride, or aluminum oxide).

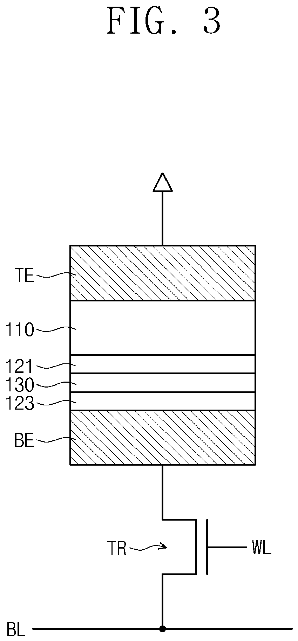

Hereinafter, the semiconductor devices according to some embodiments of inventive concepts will be described in more detail with reference to FIGS. 3 to 9. For concise description, the same element as the afore-described semiconductor device may be identified by the same reference number without repeating an overlapping description thereof.

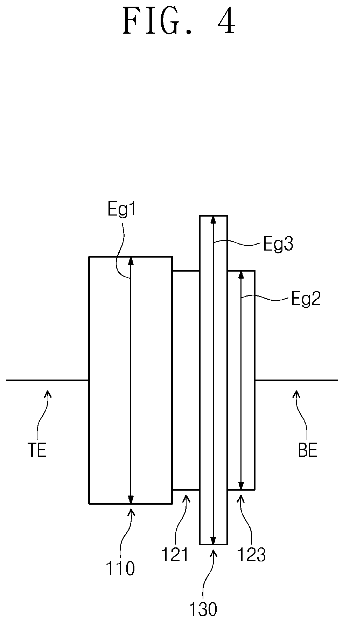

FIG. 3 is a sectional view illustrating a semiconductor device according to an embodiment of inventive concepts. FIG. 4 is an energy band diagram illustrating a semiconductor device according to an embodiment of inventive concepts.

Referring to FIGS. 3 and 4, a semiconductor device according to an embodiment of inventive concepts may include first and second anti-ferroelectric layers 121 and 123, in addition to the first electrode BE, the second electrode TE, the ferroelectric layer 110, and the insertion layer 130.

The ferroelectric layer 110 may be disposed between the first electrode BE and the second electrode TE, and the first and second anti-ferroelectric layers 121 and 123 may be disposed between the ferroelectric layer 110 and the first electrode BE. The insertion layer 130 may be disposed between the first and second anti-ferroelectric layers 121 and 123 to be spaced apart from the ferroelectric layer 110.

The first anti-ferroelectric layer 121 may be in contact with the ferroelectric layer 110. The first and second anti-ferroelectric layers 121 and 123 may have a crystalline structure different from the ferroelectric layer 110.

The first and second anti-ferroelectric layers 121 and 123 may be formed of the same anti-ferroelectric material or may be formed of anti-ferroelectric materials different from each other. Each of the first and second anti-ferroelectric layers 121 and 123 may be thinner than the ferroelectric layer 110 and may have a second energy band gap that is smaller than or equal to the first energy band gap of the ferroelectric layer 110.

The insertion layer 130 may be formed of or include a material, which has the third energy band gap Eg3 greater than the first and second anti-ferroelectric layers 121 and 123. The insertion layer 130 may serve as an energy barrier between the first and second anti-ferroelectric layers 121 and 123. The insertion layer 130 may be thinner than the first or second anti-ferroelectric layer 123.

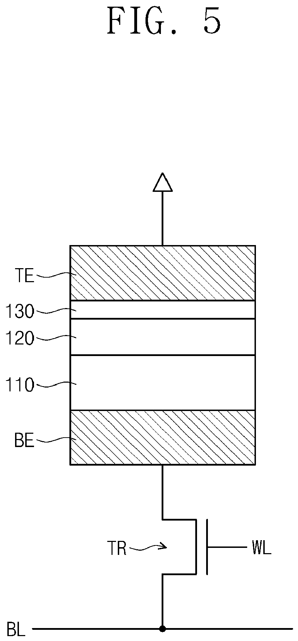

FIGS. 5 to 9 are sectional views, each of which illustrates a semiconductor device according to an embodiment of inventive concepts.

Referring to FIG. 5, a semiconductor device according to an embodiment of inventive concepts may include the first electrode BE, the second electrode TE, the ferroelectric layer 110, the anti-ferroelectric layer 120, and the insertion layer 130, as described with reference to FIG. 1. Here, the ferroelectric layer 110 may be adjacent to the first electrode BE, and the anti-ferroelectric layer 120 may be disposed between the ferroelectric layer 110 and the second electrode TE. The insertion layer 130 may be disposed between the anti-ferroelectric layer 120 and the second electrode TE to be spaced apart from the ferroelectric layer 110.

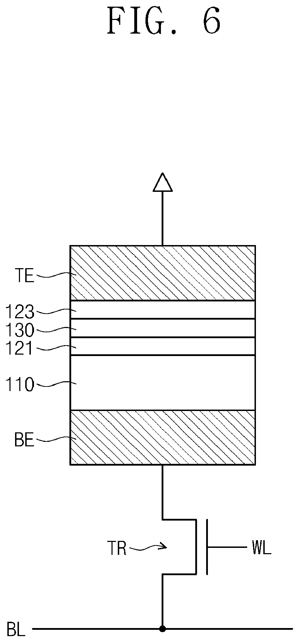

Referring to FIG. 6, a semiconductor device according to an embodiment of inventive concepts may include the first electrode BE, the second electrode TE, the ferroelectric layer 110, the first and second anti-ferroelectric layers 121 and 123, and the insertion layer 130, as described with reference to FIG. 3. Here, the ferroelectric layer 110 may be adjacent to the first electrode BE, and the first and second anti-ferroelectric layers 121 and 123 may be disposed between the ferroelectric layer 110 and the second electrode TE. The insertion layer 130 may be disposed between the first and second anti-ferroelectric layers 121 and 123 to be spaced apart from the ferroelectric layer 110. The first and second anti-ferroelectric layers 121 and 123 may be formed of the same ferroelectric material or may be formed of ferroelectric materials different from each other.

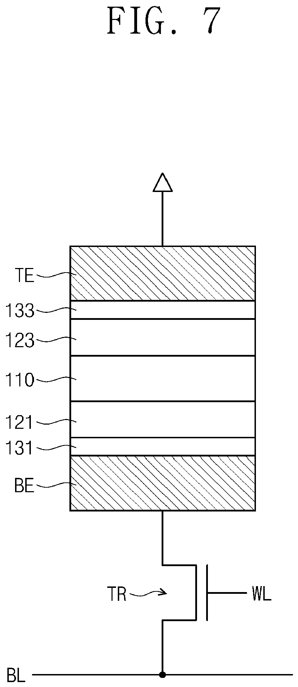

Referring to FIG. 7, a semiconductor device according to an embodiment of inventive concepts may include the first electrode BE, the second electrode TE, the ferroelectric layer 110, the first and second anti-ferroelectric layers 121 and 123, and first and second insertion layers 131 and 133.

The first anti-ferroelectric layer 121 may be disposed between the ferroelectric layer 110 and the first electrode BE, and the first insertion layer 131 may be disposed between the first anti-ferroelectric layer 121 and the first electrode BE. The second anti-ferroelectric layer 123 may be disposed between the ferroelectric layer 110 and the second electrode TE, and the second insertion layer 133 may be disposed between the second anti-ferroelectric layer 123 and the second electrode TE.

The first anti-ferroelectric layer 121 may be in contact with a first surface of the ferroelectric layer 110, and the second anti-ferroelectric layer 123 may be in contact with the second surface of the ferroelectric layer 110. The first surface of the ferroelectric layer 110 may be opposite to the second surface of the ferroelectric layer 110. The first and second anti-ferroelectric layers 121 and 123 may have a crystalline structure different from the ferroelectric layer 110.

The first and second insertion layers 131 and 133 may be formed of or include a material having an energy band gap greater than those of the first and second anti-ferroelectric layers 121 and 123. The first insertion layer 131 may provide an energy barrier between the first anti-ferroelectric layer 121 and the first electrode BE, and the second insertion layer 133 may provide an energy barrier between the second anti-ferroelectric layer 123 and the second electrode TE.

The first and second insertion layers 131 and 133 may contain second elements, which have the same valence as the first element in the first and second anti-ferroelectric layers 121 and 123, as described above. Alternatively, the first and second insertion layers 131 and 133 may contain a second element, which has an atomic radius similar to that of the first element in the first and second anti-ferroelectric layers 121 and 123.

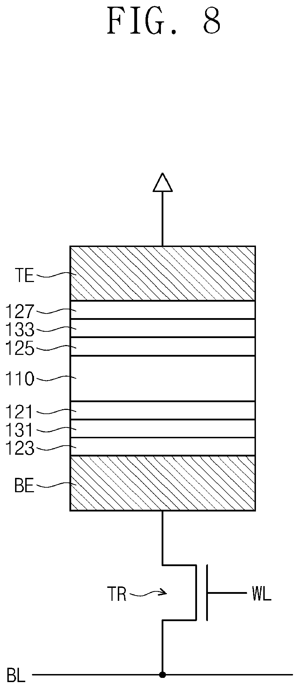

Referring to FIG. 8, a semiconductor device according to an embodiment of inventive concepts may include the first electrode BE, the second electrode TE, the ferroelectric layer 110, first, second, third, and fourth anti-ferroelectric layers 121, 123, 125, and 127, and the first and second insertion layers 131 and 133.

The first and second anti-ferroelectric layers 121 and 123 may be disposed between the ferroelectric layer 110 and the first electrode BE. The third and fourth anti-ferroelectric layers 125 and 127 may be disposed between the ferroelectric layer 110 and the second electrode TE. As an example, the first anti-ferroelectric layer 121 may be in contact with the first surface of the ferroelectric layer 110, and the third anti-ferroelectric layer 125 may be in contact with the second surface of the ferroelectric layer 110. The first surface of the ferroelectric layer 110 may be opposite to the second surface of the ferroelectric layer 110. The first, second, third, and fourth anti-ferroelectric layers 121, 123, 125, and 127 may have a crystalline structure different from the ferroelectric layer 110.

The first insertion layer 131 may be disposed between the first and second anti-ferroelectric layers 121 and 123, and the second insertion layer 133 may be disposed between the third and fourth anti-ferroelectric layers 125 and 127.

The first insertion layer 131 may be formed of or include a material having an energy band gap greater than those of the first and second anti-ferroelectric layers 121 and 123. The second insertion layer 133 may be formed of or include a material having an energy band gap greater than those of the third and fourth anti-ferroelectric layers 125 and 127.

The first and second insertion layers 131 and 133 may be formed of or include the same insulating material or different insulating materials from each other. The first and second insertion layers 131 and 133 may be thinner than the first, second, third, or fourth anti-ferroelectric layers 121, 123, 125, or 127.

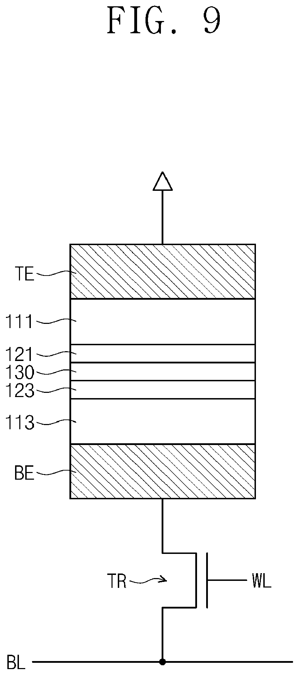

Referring to FIG. 9, a semiconductor device according to an embodiment of inventive concepts may include the first electrode BE, the second electrode TE, first and second ferroelectric layers 111 and 113, the first and second anti-ferroelectric layers 121 and 123, and the insertion layer 130, as described with reference to FIG. 1.

The first and second anti-ferroelectric layers 121 and 123 may be disposed between the first and second ferroelectric layers 111 and 113, and the insertion layer 130 may be disposed between the first and second anti-ferroelectric layers 121 and 123. The first anti-ferroelectric layer 121 may be in contact with the first ferroelectric layer 111, and the second anti-ferroelectric layer 123 may be in contact with the second ferroelectric layer 113.

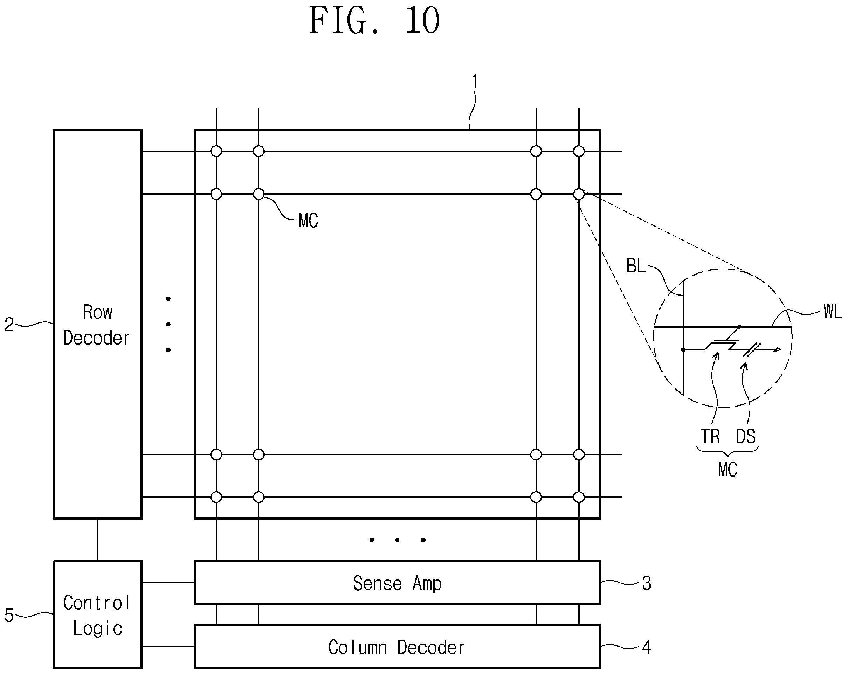

FIG. 10 is a block diagram illustrating a semiconductor memory device including a semiconductor device according to an embodiment of inventive concepts.

Referring to FIG. 10, a semiconductor memory device may include a memory cell array 1, a row decoder 2, a sense amplifier 3, a column decoder 4, and a control logic 5.

The memory cell array 1 may include a plurality of memory cells MC, which are two-dimensionally or three-dimensionally arranged. Each of the memory cells MC may be placed between and connected to the word line WL and the bit line BL, which are disposed to cross each other.

Each of the memory cells MC may include the switching device TR and a data storage device DS, and in an embodiment, the switching device TR and the data storage device DS may be electrically connected in series to each other. The switching device TR may be placed between and connected to the data storage device DS and the word line WL, and the data storage device DS may be connected to the bit line BL through the switching device TR. The switching device TR may be a field effect transistor (FET), and the data storage device DS may be realized using at least one of a capacitor, a magnetic tunnel junction (MTJ) pattern, or a variable resistor.

In an embodiment, the switching device TR may include a transistor including a gate electrode, which is connected to the word line WL, and drain/source terminals, which are respectively connected to the bit line BL and the data storage device DS.

As an example, the data storage device DS may include the capacitor described with reference to FIGS. 1 to 9.

The row decoder 2 may be configured to decode address information, which is input from the outside, and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may be used as a data transmission path between the sense amplifier 3 and an external device (e.g., a memory controller). The column decoder 4 may be configured to decode address information, which is input from the outside, and to select one of the bit lines BL, based on the decoded address information.

The control logic 5 may be configured to generate control signals, which are used to control data-writing or data-reading operations on the memory cell array 1.

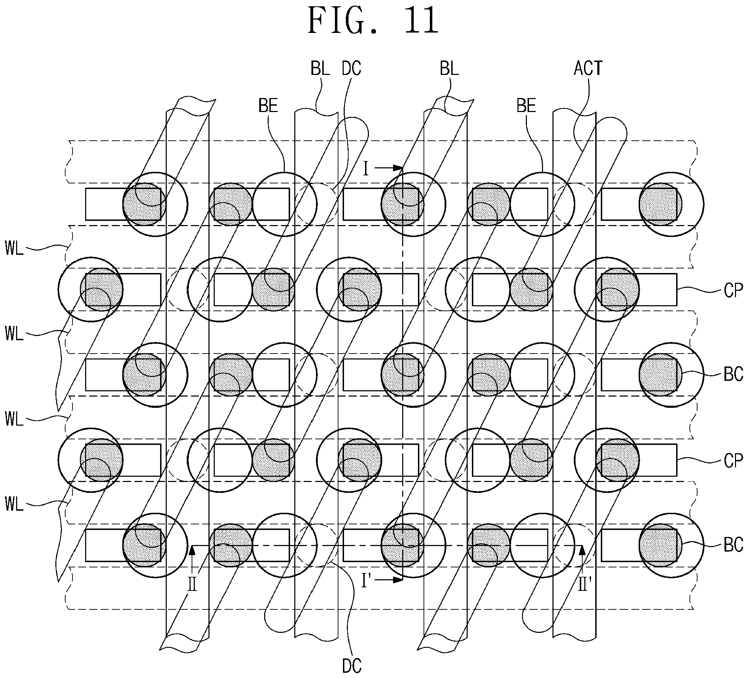

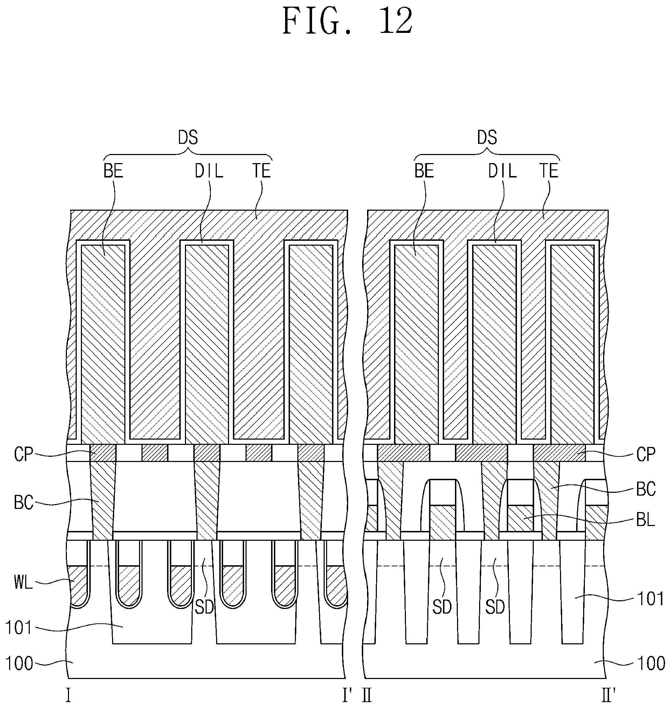

FIG. 11 is a plan view illustrating a semiconductor memory device including a semiconductor device according to an embodiment of inventive concepts. FIG. 12 is a sectional view, which is taken along lines I-I' and II-II' of FIG. 11 to illustrate a semiconductor memory device including a semiconductor device according to an embodiment of inventive concepts.

Referring to FIGS. 11 and 12, a semiconductor memory device may include the word lines WL and the bit lines BL, which are disposed to cross each other perpendicularly, and may include memory cells, which are placed at respective intersections of the word lines WL and the bit lines BL.

For example, a device isolation layer 101 may be formed on a semiconductor substrate 100 to define active regions ACT. The active regions ACT may be formed to have a bar shape, and long axes of the active regions ACT may be parallel to a diagonal direction that is inclined at an angle to both of the word and bit lines WL and BL.

The word lines WL may be disposed to cross the active regions ACT. In an embodiment, the word lines WL may be formed in a recess region, which is recessed from a top surface of the semiconductor substrate 100 to have a specific depth, and a gate insulating layer may be interposed between the word lines WL and the recess region. In addition, top surfaces of the word lines WL may be located at a level lower than a top surface of the semiconductor substrate 100, and an insulating material may be formed to fill a remaining portion of the recess region provided with the word line WL.

Source and drain regions SD may be formed in portions of the active regions ACT at both sides of the word lines WL The source and drain regions SD may be impurity regions that are doped with impurities.

Since the word lines WL and the source and drain regions SD are formed as described above, a plurality of MOS transistors may be formed on the semiconductor substrate 100.

The bit lines BL may be disposed on the semiconductor substrate 100 to cross the word lines WL An interlayer insulating layer may be interposed between the bit lines BL and the semiconductor substrate 100. The bit lines BL may be connected to a center portion (e.g., one of the source and drain regions) of each active region through bit line contact plugs DC.

Buried contact plugs BC may be disposed on the active regions ACT at both sides of the bit line BL. Contact pads may be disposed on the interlayer insulating layer covering the bit lines BL and may be connected to the active regions ACT (e.g., the source and drain regions SD), which are disposed at both sides of the bit line BL, through the buried contact plugs BC.

In the embodiment of FIGS. 11 and 12, a MOS transistor, which has a channel region formed by recessing the semiconductor substrate, may be used as a selection element of a memory cell, but inventive concepts are not limited to this example. In another embodiment, a MOS transistor whose channel pattern is provided to be perpendicular to the top surface of the semiconductor substrate may be provided as the selection element of the memory cell. In other embodiment, the selection elements of the memory cells may be three-dimensionally arranged on the semiconductor substrate. For example, word lines or bit lines may be extended in a direction perpendicular to the top surface of the semiconductor substrate.

Capacitors serving as the data storage devices DS may be respectively provided on contact pads CP. The capacitor, which is used as the data storage device DS, may include a bottom electrode BE, a top electrode TE, and a capacitor dielectric layer DIL. The capacitor, which is used as the data storage device DS, may include one of the semiconductor devices described with reference to FIGS. 1 to 9.

In an embodiment, the bottom electrode BE may correspond to the first electrode BE described with reference to FIGS. 1 to 9, and the top electrode TE may correspond to the second electrode TE described with reference to FIGS. 1 to 9. The bottom electrodes BE may be in contact with the contact pads CP, respectively, and may be arranged in a zigzag shape, when viewed in a plan view. Each of the bottom electrodes BE may have a pillar shape or a cylinder shape.

The top electrode TE may cover a plurality of the bottom electrodes BE in common, and the capacitor dielectric layer DIL may be disposed between the top electrode TE and the bottom electrodes BE. The capacitor dielectric layer DIL may cover the surfaces of the bottom electrodes BE with a uniform thickness. The capacitor dielectric layer DIL may include the ferroelectric layer 110, the anti-ferroelectric layer 120, and the insertion layer 130, as described with reference to FIGS. 1 to 9.

According to an embodiment of inventive concepts, an insertion layer may be provided to reduce a leakage current in a capacitor dielectric structure including a ferroelectric layer and an anti-ferroelectric layer.

The insertion layer may provide an energy barrier for reducing a leakage current, and since the insertion layer is spaced apart from the ferroelectric layer, it may be possible to realize a crystalline ferroelectric layer having a high dielectric constant. Accordingly, a capacitor dielectric layer may be used to effectively reduce a leakage current, even when it has a small thickness.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While example embodiments of inventive concepts have been particularly shown and described, it will be understood by one of ordinary skill in the art that variations in form and detail may be made therein without departing from the scope of the attached claims.

## Claims

1. A semiconductor device, comprising:
a first electrode;
a second electrode on the first electrode;
a ferroelectric layer between the first electrode and the second electrode;
an anti-ferroelectric layer in contact with the ferroelectric layer; and
an insertion layer spaced apart from the ferroelectric layer and in contact with the anti-ferroelectric layer.

2. The semiconductor device of claim 1, wherein
the anti-ferroelectric layer contains a first element,
the insertion layer contains a second element,
the second element is different from the first element, and
the first element and the second element have a same valence.

3. The semiconductor device of claim 1 or claim 2, wherein an energy band gap of the insertion layer is greater than an energy band gap of the anti-ferroelectric layer.

4. The semiconductor device of any preceding claim, wherein the ferroelectric layer comprises an oxide material containing hafnium or zirconium.

5. The semiconductor device of any preceding claim, wherein the ferroelectric layer has a crystal structure of tetragonal phase.

6. The semiconductor device of any preceding claim, wherein
the anti-ferroelectric layer comprises zirconium or hafnium, and
the insertion layer comprises silicon or aluminum.

7. The semiconductor device of any preceding claim, wherein a thickness of the insertion layer is smaller than a thickness of the anti-ferroelectric layer.

8. The semiconductor device of any preceding claim, wherein the insertion layer is between the anti-ferroelectric layer and the first electrode.

9. The semiconductor device of claims 1-7, wherein
the anti-ferroelectric layer comprises a first anti-ferroelectric layer and a second anti-ferroelectric layer,
the first anti-ferroelectric layer is between the ferroelectric layer and the insertion layer, and
the second anti-ferroelectric layer is disposed between the insertion layer and the first electrode.

10. The semiconductor device of claims 1-7, wherein
the insertion layer comprises a first insertion layer and a second insertion layer,
the first insertion layer is between the first electrode and the ferroelectric layer,
the second insertion layer is between the second electrode and the ferroelectric layer,
the anti-ferroelectric layer comprises a first anti-ferroelectric layer and a second anti-ferroelectric layer,
the first anti-ferroelectric layer is between the ferroelectric layer and the first insertion layer, and
the second anti-ferroelectric layer is between the ferroelectric layer and the second insertion layer.

11. The semiconductor device of claim 10, wherein
the anti-ferroelectric layer comprises a third anti-ferroelectric layer and a fourth anti-ferroelectric layer,
the third anti-ferroelectric layer is between the first insertion layer and the first electrode, and
the fourth anti-ferroelectric layer is between the second insertion layer and the second electrode.

12. The semiconductor device of any of claims 1-7, wherein
the ferroelectric layer comprises a first ferroelectric layer and a second ferroelectric layer between the first electrode and the second electrode,
the anti-ferroelectric layer comprises a first anti-ferroelectric layer and a second anti-ferroelectric layer disposed between the first ferroelectric layer and the second ferroelectric layer, and
the insertion layer is between the first anti-ferroelectric layer and the second anti-ferroelectric layer.

13. The semiconductor memory device of any preceding claim, wherein an energy band gap of the insertion layer is greater than an energy band gap of the anti-ferroelectric layer.

14. The semiconductor device of any preceding claim, further comprising:
a selection transistor;
a word line configured to control the selection transistor;
a bit line crossing the word line and connected to a source electrode of the selection transistor; and
a capacitor connected to a drain electrode of the selection transistor,
wherein the capacitor includes:
the first electrode;
the second electrode on the first electrode;
the ferroelectric layer between the first electrode and the second electrode;
the anti-ferroelectric layer in contact with the ferroelectric layer; and
the insertion layer spaced apart from the ferroelectric layer and in contact with the anti-ferroelectric layer.

15. The semiconductor memory device of claim 14, wherein
the ferroelectric layer comprises a dielectric material containing hafnium,
the anti-ferroelectric layer comprises a dielectric material containing zirconium, and
the insertion layer comprises silicon oxide or aluminum oxide.
